# EUROPEAN PATENT SPECIFICATION

(11) **EP 1 620 872 B1**
(45) Date of publication and mention of the grant of the patent: **02.02.2011**
(21) Application number: 04760119.0
(22) Date of filing: 22.04.2004
(51) Int. Cl.: H01H 13/70

(54) **MULTI-LAYER SOLID STATE KEYBOARD**
MEHRSCHICHTIGE RÖHRENLOSE TASTATUR
CLAVIER A SEMI-CONDUCTEUR MULTICOUCHE

(30) Priority: 22.04.2003 US 464483 P
(43) Date of publication of application: 01.02.2006
(73) Proprietor: TouchSensor Technologies, L.L.C., Wheaton, Illinois 60187 (US)
(72) Inventor: SCHAEFER, William, David, Grand Rapids, MI 49504 (US); CALDWELL , David, W., Holland, MI 49424 (US)
(74) Representative: Hackett, Sean James
(86) International application number: PCT/US2004/012419
(87) International publication number: WO 2004/095488

(56) References cited:
- DE-U- 9 112 597
- US-A- 4 901 074
- US-A- 5 239 152
- US-A- 6 137 072

## Description

### BACKGROUND OF THE INVENTION

### 1. The Technical Field

The present invention is directed generally to a solid state keyboard. More particularly, the present invention is directed to a solid state keyboard integrating decorative and functional layers.

### 2. The Related Art

Keypad input systems typically are assemblies of several components. For example, a typical keypad includes a glass, plastic, or flexible film face plate or front panel that acts as a user interface. This face plate might include graphics that describe the keypad's functionality and/or other indicia, such as a logo, for purely decorative purposes. Such a keypad further includes another panel that includes, for example, field effect sensor electrodes and control circuitry. These two panels typically are manufactured as separate subassemblies that are later joined to form a finished keypad.

Some keypads use reconfigurable keys in connection with a reconfigurable display. One example of such a system includes a dot matrix display that provides prompts to a user and solicits input from the user via one or more mechanical switches, for example, membrane switches, situated about the display and proximate the various prompts. Such a system may guide a user through various menu levels, wherein the displayed prompts corresponding to a particular switch vary from level to level and the function of the switch changes correspondingly. One drawback with such a system is that it is not always clear to the user which switch, if any, is associated with a particular display prompt. Another is that membrane switches, commonly used in such applications, are prone to premature failure when used in high traffic applications.

Computer touch screen technology, as sometimes used in connection with cash register input pads and consumer product information kiosks, offers a better solution, but involves greater cost and complexity. Indeed, such systems typically require PC-based or proprietary decoding hardware. Further, the hardware requirements for such systems prohibit their use in applications where little space is available.

An example of keypad input system is disclosed in US-A-6 137 072.

### SUMMARY OF THE INVENTION

In embodiments of the present invention, an integrated solid state keypad has multiple layers, including decorative layers and functional layers, as defined in claim 1. The keypad includes one or more keys which preferably are embodied as field effect sensors. In certain embodiments, one or more of the keys are reconfigurable keys that can be used in connection with a reconfigurable display. Preferably, the reconfigurable keys are embodied as field effect sensors having transparent electrode structure.

### BRIEF DESCRIPTION OF THE DRAWINGS

FIG. 1 is a front elevation view of a keypad according to the present invention;
FIG. 2 is a side elevation view of a keypad according to the present invention;
FIG. 3 is a rear elevation view of a keypad according to the present invention, illustrating a transparent conductive layer on a substrate;
FIG. 4 is a rear elevation view of a keypad according to the present invention, illustrating a conventional conductive layer on a substrate;
FIG. 5 is a rear elevation view of a keypad according to the present invention, illustrating a solder mask or dielectric layer on a substrate;

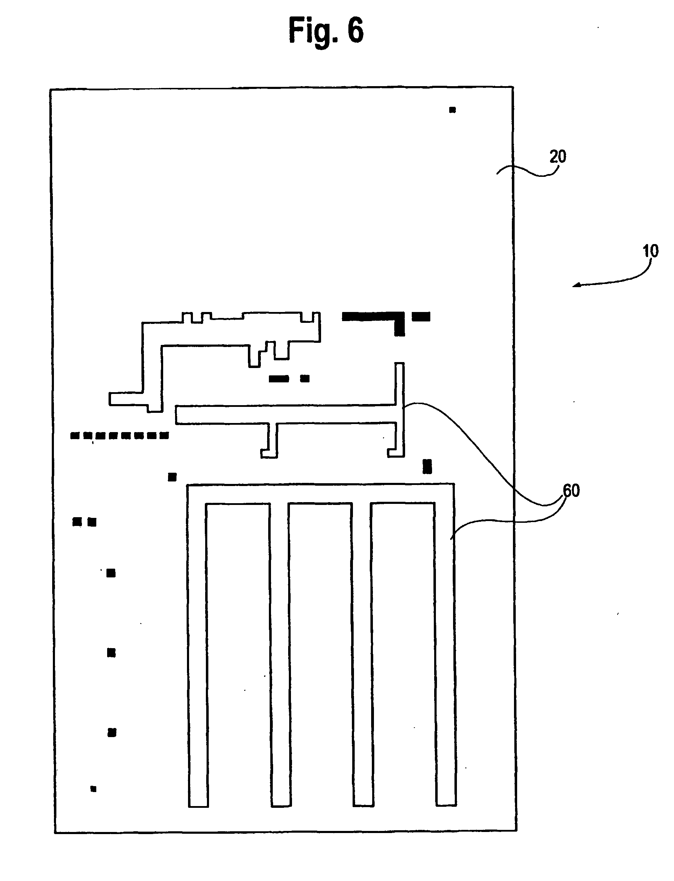

FIG. 6 is a rear elevation view of a keypad according to the present invention, illustrating an additional dielectric layer on a substrate; and
FIG. 7 is a rear elevation view of a keypad according to the present invention, illustrating crossovers for connecting a first conductive layer to a second conductive layer.

### DETAILED DESCRIPTION OF THE ILLUSTRATED EMBODIMENT

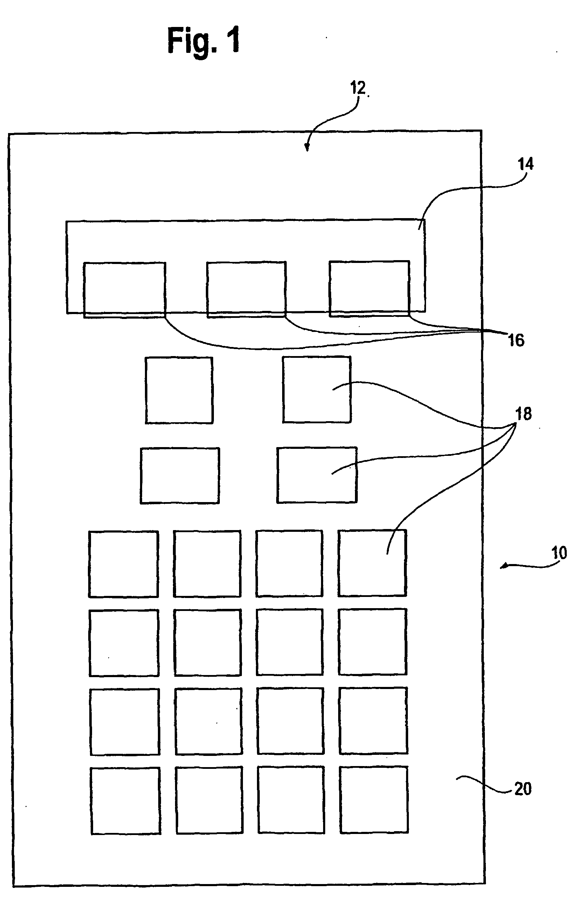

FIG. 1 illustrates the front, or user interface, side 12 of a keypad 10 according to a preferred embodiment of the present invention. Keypad 10 includes a viewing window 14, three reconfigurable keys 16, and twenty non-reconfigurable keys 18 disposed on a substrate 20. Keys 16,18 correspond to field effect sensors, capacitive sensors, or other sensors disposed on the rear side of keypad 10, as will be discussed further below. The precise combination of features illustrated in FIG. 1 is not essential to the invention and is shown for illustration only. Indeed, other embodiments of the invention could have more or fewer viewing windows, reconfigurable keys, or non-reconfigurable keys. Further, some embodiments might lack one or more of these features entirely.

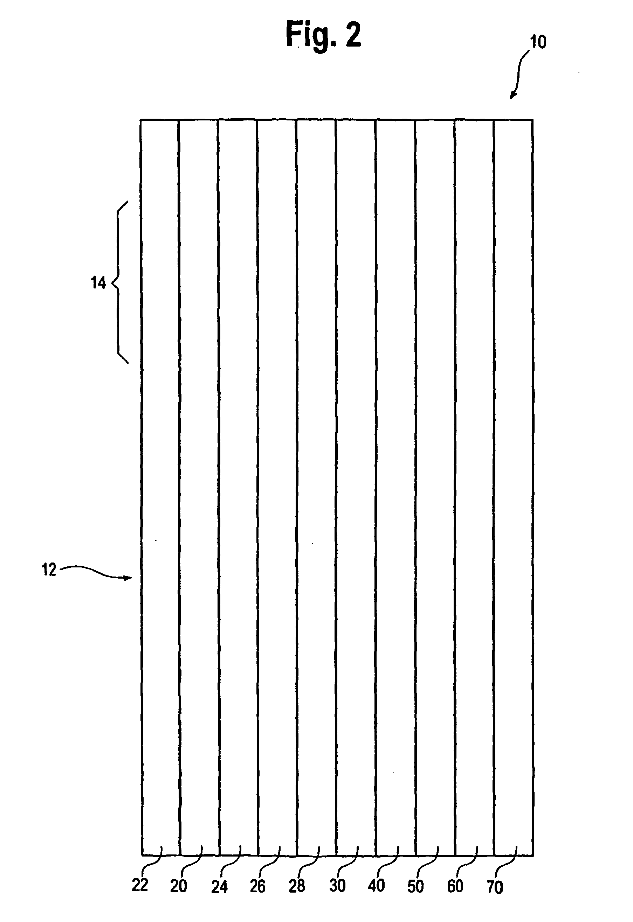

FIG. 2 is a side elevation view showing the various layers comprising keypad 10. FIG. 2 illustrates a preferred arrangement of the various layers. In other embodiments, the various layers can be arranged in other ways and/or sequences, as would be understood by one skilled in the art. Substrate 20, which forms the core of keypad 10, can be any rigid or flexible material suitable for receiving decorative materials and conductive thin films. For example, substrate 20 can be a piece of glass or plastic or a flexible carrier made of polyester.

Layers 22,24,26,28 are layers of decorative material. These decorative material layers can provide functional information, such as graphics depicting the function of a particular key, or purely decorative graphics, for example, a decorative pattern or logo, are applied to one or both sides of substrate 20. FIG. 2 illustrates one decorative layer 22 on the user interface side of substrate 20 and three decorative layers 24,26,28 on the rear side of substrate 20. In other embodiments more or fewer decorative layers can be used on each side of substrate 20.

In preferred embodiments, decorative layers 22,24,26,28 comprise organic decorative materials, for example, screen printed inks, epoxies, and ultraviolet curable materials. Other decorative materials, including inorganic materials, can be used, as well. The various decorative layers can be substantially opaque, translucent, or substantially transparent. In embodiments having viewing window 14, any decoration located within the area of viewing window 14 preferably is substantially transparent so that a user can view a display (not shown) that might be mounted behind viewing window 14 or so that backlighting can be penetrate viewing window 14. Further, decoration located within the area of viewing window 14 can be selected to have certain optical properties so that such decoration acts as an optical filter.

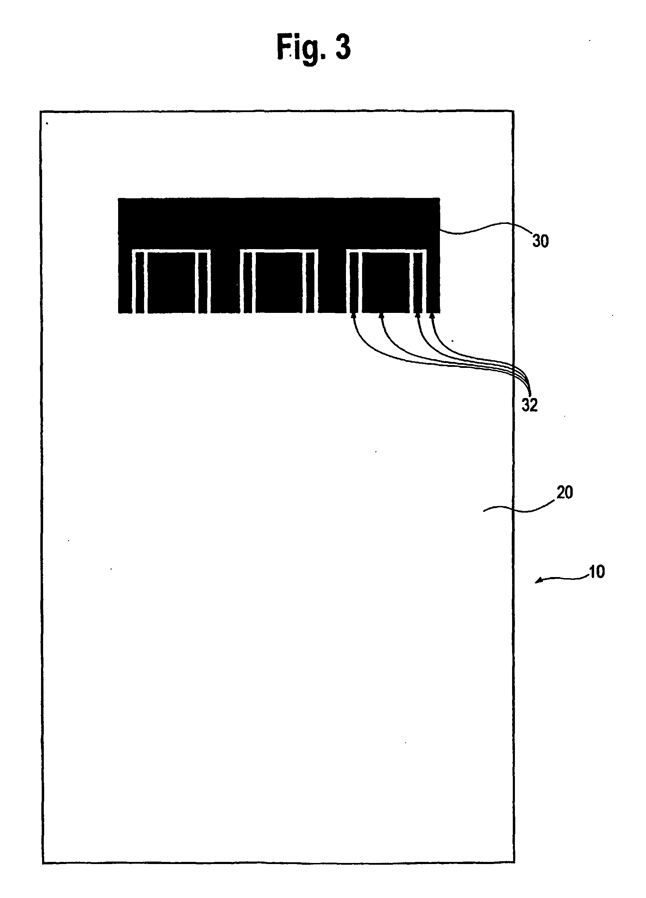

Layer 30 is an optional, substantially transparent layer of conductive material. Referring to FIG. 3, transparent conductive layer 30, when used, preferably is configured as transparent electrodes and electrical circuit traces 32. Transparent electrodes and traces 32 can be located anywhere on substrate 28. For example, transparent electrodes and traces 32 can be located on decorated portions of substrate 18, between substrate 18 and the decoration, such the decoration is viewable through transparent electrodes and traces 32. In applications using backlighting, transparent electrodes and traces 32 can be used in backlit portions to allow the backlighting to reach the user without occlusion as would be the case if electrodes and traces 32 were made of a conventional, opaque material. Referring to FIG. 1, it can be particularly desirable to use transparent electrodes and traces 32 to embody reconfigurable keys 16 or other keys located in the area corresponding to viewing window 14 so that the output of a display (not shown) mounted behind viewing window 14 is visible to the user.

As discussed further below, electrical circuit components can be coupled to transparent electrodes and traces 32 to form field effect sensors, capacitive sensors, or other sensors. Transparent conductive layer 30 can be applied in various ways. For example, transparent conductive layer 30 can be deposited in a desired pattern using screen printing or micro-deposition techniques. Alternatively, transparent conductive layer 30 can be plated or applied as a thin film utilizing, for example, sputtering or thermal evaporation techniques, and then patterned and etched to yield transparent electrodes and traces 32. Other suitable techniques, for example, spin coating, also can be used to apply transparent conductive layer 30, as would be known to one skilled in the art.

FIG. 2 illustrates transparent conductive layer 30 disposed onto decorative layer 28, which ultimately is disposed on substrate 20. Alternatively, transparent conductive layer 30 can be disposed directly onto substrate 20. In such an embodiment, a decorative layer (not shown) optionally can be disposed on transparent conductive layer 30. In embodiments where transparent conductive electrodes and traces 32 are disposed above or below one or more decorative layers, at least the portions of such decorative layers that are coextensive with transparent conductive layer 30 preferably are substantially transparent and can comprise material having optical filtering properties. Preferred materials for transparent conductive layer 30 include, for example, inorganic materials, such as indium tin oxide, or organic materials, such as Baytron PEDOT.

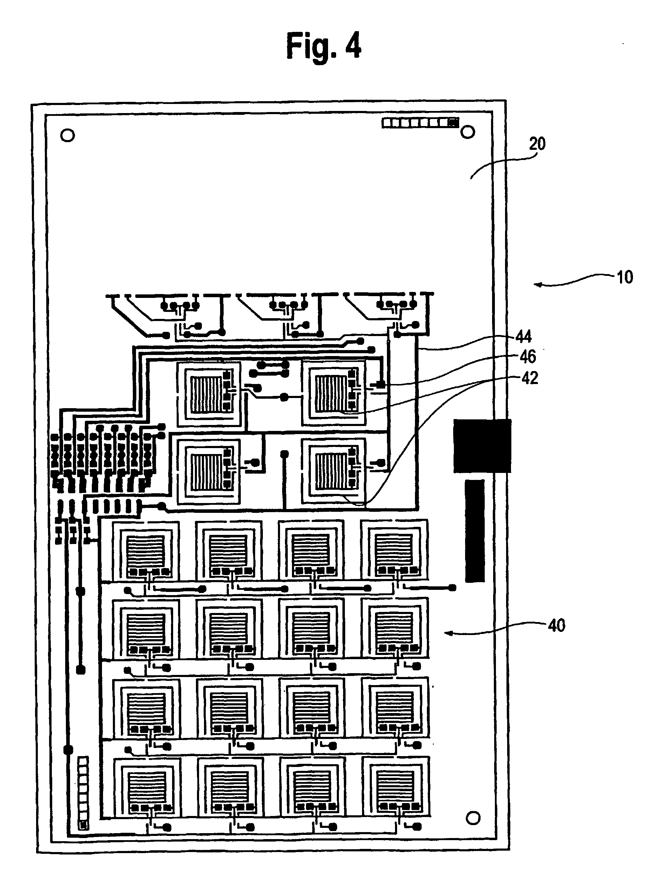

Layer 40 is a layer of conventional conductive material disposed on transparent conductive layer 30. Preferably, conventional conductive material layer 40 is made of a polymer thick film silver or copper epoxy, such as that supplied by Acheson Colloids Company of Port Huron, Michigan. In other embodiments, this layer can be made of plated copper or other conductive material. Referring to FIG. 4, conventional conductive layer material 40 preferably is arranged in the form of field effect sensor electrodes 42, electrical circuit traces 44, and bonding pads 46. As discussed further below, electrical circuit components, for example, integrated circuits, transistors, and resistors (not shown), can be coupled to electrodes 42 and traces 44 via bonding pads 46 to form field effect sensors, capacitive sensors, or other sensors. Preferably, such components are connected to bonding pads using conventional soldering techniques. Alternatively, such connections can be made using conductive adhesives, anisotropic adhesives, or other suitable means, as would be known to one skilled in the art. Conventional conductive material layer 40 can be applied using any suitable technique as would be known to one skilled in the art, for example, any of the techniques discussed above in connection with the application of optional transparent conductive layer 30.

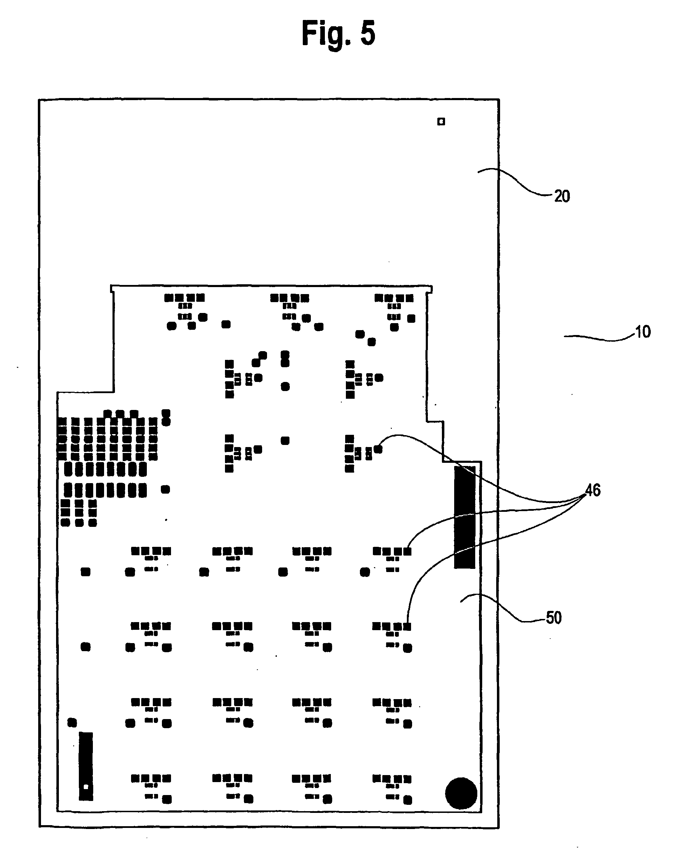

Referring to FIGS. 2 and 5, layer 50 is a solder mask/dielectric layer disposed on conventional conductive layer 40 and/or transparent conductive layer 30. Layer 50 provides a solder mask, leaving exposed the portions of conductive layer 40 to which electrical circuit components are to be bonded. For example, solder mask 50 can be designed to leave exposed bonding pads 46 to facilitate bonding of integrated circuits and other electrical components to bonding pads 46. In this manner, field effect sensors or other sensors corresponding to keys 16,18 can be constructed *in situ* on substrate 20. Although it generally is not preferred to couple such circuit components directly to transparent conductive layer 30, solder mask layer 50 can be designed to leave exposed portions of transparent conductive layer, as necessary, to facilitate such bonding.

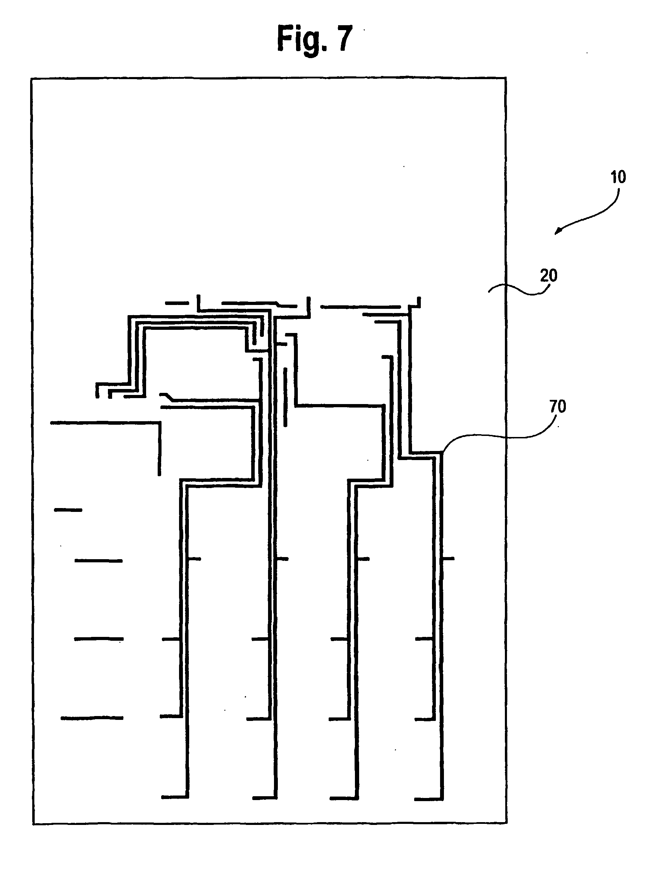

Layer 50 also can provide electrical insulation between conventional conductive material layer 40 and transparent conductive layer 30 and further layers of keypad 10. For example, a particular circuit design might require the use of crossovers 70, as illustrated in FIG. 7 and as would be known to one skilled in the art. If layer 50 is selected to have suitable dielectric properties, such crossovers can be applied over layer 50 and bonded at the appropriate points to conventional conductive layer 40 (and/or transparent conductive layer 30, as necessary). In such embodiments, layer 50 insulates crossovers 70 from portions of conventional conductive layer 40 (and/or transparent conductive layer 30, as necessary) which crossovers 70 otherwise would contact, causing the potential for short circuits.

Layer 60 is an optional dielectric layer that can be used in embodiments involving crossovers 70. As discussed above in connection with layer 50, optional dielectric layer 60 provides electrical insulation between electrical crossovers and conductive portions of keypad 10 to be bridged by such crossovers.

A reconfigurable display (not shown) can be disposed on the rear side of keypad 10 adjacent the area corresponding to viewing window 14, allowing a user to view the display through viewing window 14. Such embodiments preferably include reconfigurable keys 14 comprising field effect sensors or other sensors having transparent electrode structure with in the area corresponding to viewing window 14. The functions of such sensors preferably would be reconfigurable, as would be known to one skilled in the art, to conform to the subject matter set forth in the display in the area corresponding to such sensors.

## Claims

1. A solid state keyboard comprising:
a substrate (20);
at least one layer of decorative material (24) disposed on said substrate;
a thin film of a first substantially transparent conductive material (30) disposed on said decorative material or said substrate, said thin film of a first conductive material being configured as a transparent first electrode and first electrical circuit trace (32);
a layer of second conductive material (40) disposed on said first substantially transparent conductive material, said layer of a second conductive material arranged in the form of a second electrode (42) a second electrical circuit trace (44), and bonding pads (46); and
an electrical circuit component coupled to said second electrode (42) and said second electrical circuit trace (44) via said bonding pad to form a sensor corresponding to a key (16, 18).

2. The solid state keyboard of claim 1 wherein said decorative material comprises an organic material.

3. The solid state keyboard of claim 2 wherein said organic material comprises an epoxy.

4. The solid state keyboard of claim 1 wherein said electrical component is soldered to said bonding pad.

5. The solid state keyboard of claim 1 further comprising a mask (50) disposed on at least a portion of said thin film of a first conductive material and at least a portion of said layer of a second conductive material, said mask being arranged in a form that enables electrically coupling said electrical component to said bonding pad.

6. A solid state keyboard as defined in any of claims 1 to 5 further comprising a viewing window (14) and a reconfigurable display disposed on a rear side of said keyboard adjacent said viewing window.

## Patentansprüche

1. Festkörpertastatur, die Folgendes umfasst:
ein Substrat (20);
wenigstens eine Schicht aus dekorativem Material (24), die auf dem Substrat angeordnet ist;
einen Dünnfilm aus einem ersten im Wesentlichen transparenten leitenden Material (30), das auf dem dekorativen Material oder dem Substrat angeordnet ist, wobei der Dünnfilm aus einem ersten leitenden Material als transparente erste Elektrode und einer ersten elektrischen Leiterbahn (32) konfiguriert ist;
eine Schicht aus einem zweiten leitenden Material (40), die auf dem ersten im Wesentlichen transparenten leitenden Material angeordnet ist, wobei die Schicht aus einem zweiten leitenden Material in Form einer zweiten Elektrode (42), einer zweiten elektrischen Leiterbahn (44) und Bondinseln (46) angeordnet ist; und
eine elektrische Schaltungskomponente, die mit der zweiten Elektrode (42) und der zweiten elektrischen Leiterbahn (44) über die Bondinsel gekoppelt ist, um einen Sensor zu bilden, der einer Taste (16, 18) entspricht.

2. Festkörpertastatur nach Anspruch 1, wobei das dekorative Material ein organisches Material umfasst.

3. Festkörpertastatur nach Anspruch 2, wobei das organische Material ein Epoxid umfasst.

4. Festkörpertastatur nach Anspruch 1, wobei die elektrische Komponente auf die Bondinsel gelötet wird.

5. Festkörpertastatur nach Anspruch 1, die ferner eine Maske (50) umfasst, die auf wenigstens einem Teil des Dünnfilms aus einem ersten leitenden Material und wenigstens einem Teil der Schicht aus einem zweiten leitenden Material angeordnet ist, wobei die Maske in einer solchen Form vorliegt, dass die elektrische Komponente mit der Bondinsel elektrisch gekoppelt werden kann.

6. Festkörpertastatur wie in einem der Ansprüche 1 bis 5 definiert, die ferner ein Sichtfenster (14) und ein umkonfigurierbares Display umfasst, das auf einer Rückseite der Tastatur neben dem Sichtfenster angeordnet ist.

## Revendications

1. Clavier à semi-conducteur comprenant :
un substrat (20) ;
au moins une couche de matériau décoratif (24) disposée sur ledit substrat ;
un film mince d'un premier matériau conducteur sensiblement transparent (30) disposé sur ledit matériau décoratif ou ledit substrat, ledit film mince d'un premier matériau conducteur étant configuré sous forme d'une première électrode transparente et d'une première trace de circuit électrique (32) ;
une couche d'un second matériau conducteur (40) disposée sur ledit premier matériau conducteur sensiblement transparent, ladite couche d'un second matériau conducteur est agencée sous la forme d'une seconde électrode (42), d'une seconde trace de circuit électrique (44) et de plots de connexion (46) ; et
un composant de circuit électrique couplé à ladite seconde électrode (42) et à ladite seconde trace de circuit électrique (44) via ledit plot de connexion pour former un capteur correspondant à une touche (16, 18).

2. Clavier à semi-conducteur selon la revendication 1, dans lequel ledit matériau décoratif comprend un matériau organique.

3. Clavier à semi-conducteur selon la revendication 2, dans lequel ledit matériau organique comprend un époxy.

4. Clavier à semi-conducteur selon la revendication 1, dans lequel ledit composant électrique est brasé sur ledit plot de connexion.

5. Clavier à semi-conducteur selon la revendication 1, comprenant en outre un masque (50) disposé sur au moins une partie dudit film mince d'un premier matériau conducteur et au moins une partie de ladite couche d'un second matériau conducteur, ledit masque étant agencé sous une forme qui permet un couplage électrique dudit composant électrique audit plot de connexion.

6. Clavier à semi-conducteur tel que défini dans l'une quelconque des revendications 1 à 5 comprenant en outre une fenêtre de visualisation (14) et un affichage reconfigurable disposé sur un côté arrière du clavier à côté de ladite fenêtre de visualisation.
